# EUROPEAN PATENT SPECIFICATION

(11) **EP 1 569 330 B1**
(45) Date of publication and mention of the grant of the patent: **03.05.2006**
(21) Application number: 04003949.7
(22) Date of filing: 20.02.2004
(51) Int. Cl.: H03F 1/02, H03G 3/30, H04B 7/005

(54) **Method and apparatus for improving power amplifier efficience in wireless communication systems having high peak to average power ratios**
Verfahren und Vorrichtung für erhöhten Wirkungsgrad eines Leistungsverstärkers in Funkübertragungssystemen mit hohen Leistungsformfaktoren
Procédé et appareil pour améliorer l'efficacité d'un amplificateur de puissance dans des systèmes de communication sans fil au rapport puissance de crête/puissance moyenne haut

(43) Date of publication of application: 31.08.2005
(73) Proprietor: Research In Motion Limited, Waterloo, Ontario N2L 3W8 (CA)
(72) Inventor: Chan, Wen-Yen, Thornhill Ontario L4J 6N6 (CA); Khan, Nasserullah, Waterloo Ontario N2K 2W6 (CA); Jiao, Qingzhong, Nepean Ontario K2H 7X6 (CA); Jin, Xin, Ottawa Ontario K2E 6J6 (CA); Sangary, Nagula Tharma, Waterloo Ontario N2T 2T9 (CA); Habicher, Michael F., Waterloo, Ontario N2L 6B9 (CA)
(74) Representative: Rickard, David John

(56) References cited:
- US-A- 5 452 473
- US-A1- 2002 013 157
- US-B1- 6 359 504
- US-B1- 6 535 066
- US-B2- 6 560 446

## Description

This invention relates to wireless communication devices. More particularly, it relates to a method and apparatus for improving power amplifier efficiency in wireless communication systems having variable transmit power in a large range and/or high peak to average power ratios.

Handheld wireless communication devices and other types of wireless transmitters are typically powered by one or more internal batteries. A major performance criterion for such devices is their battery life, which is typically defined as the time period for which the battery will power the device on a single charge. A large portion of battery power is consumed in a power amplifier section of the wireless device's transmitter. The power amplifier section amplifies the power of a signal to be transmitted from a comparatively low internal power level to a substantially higher power level required for wireless communication with remote base stations and other devices. Improving the power amplifier efficiency, or more generally the transmitter efficiency, would reduce power consumption and increase battery life.

US 2002/0013157 discloses a radio communications apparatus that comprises multiple variable power amplifiers, a variable power amplification unit, and a variable power amplification control unit for controlling the variable power amplifiers. In particular, US2002/0013157 teaches combining a variable power amplifier that has a high control sensitivity with one that has a low control sensitivity and providing an appropriate control ratio to improve transmission power accuracy rather than power amplifier efficiency.

Accordingly, there is a need for a system that provides improved power amplifier efficiency, or more generally, improved transmitter efficiency.

### Summary of the Invention

The invention provides a power management system that supplies a variable power supply signal to a power amplification stage of an output power amplification block of a wireless communications device. The desired power of an amplified transmission signal that is produced by the power amplification stage is estimated and used to vary the power supply voltage that is provided to the output power amplifier, to reduce power loss in the power amplification stage. Advantageously, the estimated desired power is adjusted according to at least one environmental information signal. For instance, at least one of a temperature information signal, a battery condition signal and the operating frequency of the wireless communications device can be used to augment the estimated desired power level to provide more accurate control of the power supply signal.

In a first aspect, the invention provides a power management system for providing a variable power supply signal to an output power amplifier block in a wireless communication device, the power management system comprising: a) an average power and gain control block for providing a gain control signal in response to at least one of a power control instruction signal and a received signal strength indicator signal and providing the gain control signal to the output power amplifier block; b) an environmental sensor unit for providing at least one environmental information signal; c) a power supply level adjustment generator connected to the environmental sensor unit for providing an altered version of a power supply level adjustment signal in response to a data parameter indication of a baseband outgoing data stream to be transmitted by the wireless communication device and the at least one environmental information signal; and, d) a power supply means connected to the average power and gain control block and the power supply level adjustment generator, the power supply means provides the variable power supply signal to the output power amplifier block by providing a first power control signal based on the gain control signal and the altered version of the power supply level adjustment signal, clipping the first power control signal to provide a second power control signal and generating the variable power supply signal based on the second power control signal, wherein, the gain control signal is adapted for applying sufficient gain to a transmission signal version of the baseband outgoing data stream and the altered version of the power supply level adjustment signal is adapted for providing a small sufficient amount of headroom to efficiently provide power to transmit the transmission signal.

Preferably, the positive and negative saturation values and slope used in clipping are adjusted based on the at least one environment signal and the altered version of the gain control signal.

Preferably, the average power and gain control block provides an altered version of the gain control signal and the power supply means comprises: e) a summer connected to the average power and gain control block and the power supply level adjustment generator for summing the gain control signal and the altered version of the power supply level adjustment signal to generate the first power control signal; f) a clipper connected to the summer for receiving the first power control signal and generating the second power control signal; g) a switch converter connected to the clipper for receiving the second power control signal and generating the variable power supply signal; and, h) a reverse mapper connected to the power supply level adjustment generator and the average power and gain control block for receiving an environmental signal and the altered version of the gain control signal respectively and generating a clipper adjustment signal, the reverse mapper also being connected to the clipper for providing the clipper adjustment signal to the clipper for adjusting the positive and negative saturation values and slope of the clipper.

Preferably, the environmental sensor unit comprises any one or a combination of: e) a temperature sensor for providing a temperature information signal as part of the at least one environmental information signal, the temperature information signal being related to the temperature of the hardware of the wireless communications device ; and, f) a battery condition sensor for providing a battery condition information signal as part of the at least one environmental information signal, the battery condition information signal being related to a battery used to power the wireless communication device.

The at least one environmental information signal may comprise a frequency information signal related to the frequency at which the base band outgoing data stream will be transmitted and the power supply means may be is configured to maintain the variable power supply signal above a minimum voltage level.

Preferably, the power supply level adjustment generator is implemented by a plurality of look-up tables, wherein one look-up table is provided for each environmental information signal and the data parameter indication, and the outputs of each look-up table are combined to generate the altered version of the power supply level adjustment signal. At least one of the look-up tables may be implemented by a corresponding formula.

Preferably, the system further comprises a data parameter detector connected to the power supply level adjustment generator and a baseband device of the wireless communications device, wherein the data parameter detector provides the data parameter indication.

Preferably, the power supply block is calibrated by: i) transmitting the wireless device radio signals at a constant power level from the wireless communication device while monitoring an Adjacent Channel Power Ratio (ACPR); ii) reducing the magnitude of the variable power supply signal while maintaining constant output power in the wireless device radio signals; iii) recording the magnitude of the variable power supply signal when the ACPR has increased to a pre-specified design target; iv) increasing the output power of the wireless device radio signals and repeating steps (i) to (iii) for several output power levels; and, v) computing an ideal transfer function for deriving the power control signal for controlling the switch converter.

The power supply block may be further calibrated by: vi) repeating steps (i) to (v) for several different wireless communication devices (10) to obtain an average transfer function; and, vii) performing curve fitting on the average transfer function.

The power supply level adjustment generator may be calibrated by: viii) loading the power supply level adjustment generator with a value which causes the output power amplifier block to operate at a lowest transmission power point; ix) calibrating the transmission power until the output power of the output power amplifier block slightly exceeds a target power determined for a power supply voltage level; x) interpolating the output value of the average power level block and loading this interpolated output value, after adjustment by a reverse mapper, into the power supply level adjustment generator; xi) adjusting the transmission power level to a value slightly below the target power; and, xii) increasing the value of the transmission power level and repeating steps (viii) to (xi) until a maximum specified transmission power point is reached.

According to another aspect of the present invention there is provided a method of supplying a variable power supply signal to an output power amplifier block in a wireless communications device that receives an incoming data stream from a base station radio signal and transmits an outgoing data stream in a wireless device radio signal, the method comprising: a) detecting at least one of a signal strength of the base station radio signal to produce a received signal strength indicator signal, and a power control instruction signal in the base station radio signal; b) generating as an output a gain control signal in response to at least one of the received signal strength indicator signal and the power control instruction signal; c) generating at least one environmental information signal for obtaining information about the environment of the wireless communications device; d) generating an altered version of a power supply level adjustment signal based on a data parameter indication of a baseband outgoing data stream and the at least one environmental information signal; e) providing a first power control signal based on the gain control signal and the altered version of the power supply level adjustment signal, clipping the first power control signal to provide a second power control signal, and generating the variable power supply signal based on the second power control signal; and, f) providing the variable power supply signal and the gain control signal to the output power amplifier block, wherein, the gain control signal is adapted for applying sufficient gain to a transmission signal version of the baseband outgoing data stream and the altered version of the power supply level adjustment signal is adapted for providing a small sufficient amount of headroom to efficiently provide power to transmit the transmission signal.

Step (e) may comprise: adding the altered version of the power supply level adjustment signal and the gain control signal to provide the first power control signal, the altered version of the power supply level adjustment signal being generated based on the derivation of the gain control signal.

Step (e) may comprise generating an altered version of the gain control signal and providing a clipper adjustment signal to adjust positive and negative saturation values and slope used in clipping, the clipper adjustment signal being generated in response to a combination of the at least one environmental information signal and the altered version of the gain control signal.

Step (c) may comprise at least one of: i) generating a temperature information signal related to the temperature of the hardware of the wireless communications device and providing the temperature information signal as part of the at least one environmental information signal; ii) generating a battery condition information signal related to a battery used to power the wireless communications device and providing the battery condition information signal as part of the at least one environmental information signal; and, iii) generating a frequency information signal related to the frequency at which the outgoing data stream is transmitted and providing the frequency information signal as part of the at least one environmental information signal.

The method may further comprise maintaining the variable power supply signal above a minimum voltage level.

The present invention also provides a wireless communications device comprising the power management system and a computer readable medium comprising code means executable by a processor of the device for implementing the claimed method..

### Brief Description of the Drawings

For a better understanding of the invention and to show more clearly how it may be carried into effect, reference will now be made, by way of example only, to the accompanying drawings which show exemplary embodiments of the invention and in which:
Figure 1 is a block diagram of an exemplary embodiment of a power management system for a wireless communications device;
Figure 2 is more detailed block diagram of the power management system of Figure 1;
Figure 3 is a graph illustrating the relationship between the instantaneous maximum power required by a power amplifier of a wireless communication device and the power supply provided to the power amplifier;
Figure 4 is a block diagram of another embodiment of a power management system for a wireless communications device;
Figure 5 is a block diagram of another embodiment of a power management system for a wireless communications device;
Figure 6 is a graph illustrating the relationship between a desired power level and a power control signal according to the embodiment of Figure 5;
Figure 7a is flow chart showing the steps of a first calibration method used to calibrate the power management system; and,
Figure 7b is a flow chart showing the steps of a second calibration method used to calibrate the power management system.

### Detailed Description of Exemplary Embodiments

In the following detailed description, numerous specific details are set forth in order to provide a thorough understanding of the invention. However, it will be understood by those of ordinary skill in the art that the invention may be practiced without these specific details. In other instances, well-known methods, procedures and components have not been described in detail so as not to obscure the invention.

As is well understood, a wireless communications device generates an internal data signal that is transmitted using a radio transmitter. The data signal is typically a comparatively low frequency signal that is generally referred to as a baseband signal. The baseband signal is mixed with a carrier signal having a substantially higher frequency to produce a transmission signal. The transmission signal is amplified in one or more amplification stages of an output power amplification block to produce an amplified transmission signal that is sufficiently powered so that it is received with little or no data loss at a remote base station or another communication device.

Typically, the amplification stages of the output power amplification block include a pre-amplification stage for producing a pre-amplified transmission signal and a power amplification stage for producing the amplified transmission signal. The amplification level of the pre-amplification stage is controlled using a gain control block which is typically implemented via a gain controller. The amplification level is generally set using various open and/or closed loop methods for determining the desired power level of the amplified transmission signal. The pre-amplified transmission signal is then amplified again in the power amplification stage to generate the amplified transmission signal. The gain of the power amplification stage is typically fixed but may vary with the power supply level. The power amplification stage is powered so that it can produce an amplified transmission signal that has the instantaneous maximum power that may be required for transmission.

The above power supply scheme for the power amplification stage may be acceptable in a wireless device in which the amplified transmission signal does not have a large dynamic range of power levels, or in which the amplified transmission signal has a very low peak-to-average power ratio (PAPR). However, in many cases, the amplified transmission signal has a large dynamic range of power levels, in order to accommodate a signal that has a high PAPR, or to accommodate different types of signals that may have different desired power levels and different PAPRs. The power amplification stage must be capable of generating an amplified transmission signal such that the highest instantaneous power level desired for any data type or data rate of the baseband data that is present in the amplified transmission signal is always accommodated. Accordingly, in conventional power management schemes, the power amplification stage is always provided with a maximum amount of power supply voltage that is sufficient for accommodating a specified maximum instantaneous power level. However, much of the time, the actual instantaneous power level of the amplified transmission signal may be well below the specified maximum instantaneous power level thereby leading to inefficient operation of the power amplification stage during signal transmission. The excess power supplied to the power amplifier is dissipated as heat or otherwise lost.

The invention provides a power management system that supplies a variable power supply signal to a power amplification stage of an output power amplification block of a wireless communications device. The desired power of an amplified transmission signal, that is produced by the power amplification stage, is estimated and used to vary the power supply level to the power amplifier to reduce power loss in the power amplification stage. Advantageously, to increase accuracy, the estimated desired power is also based on at least one environmental information signal as is further discussed below.

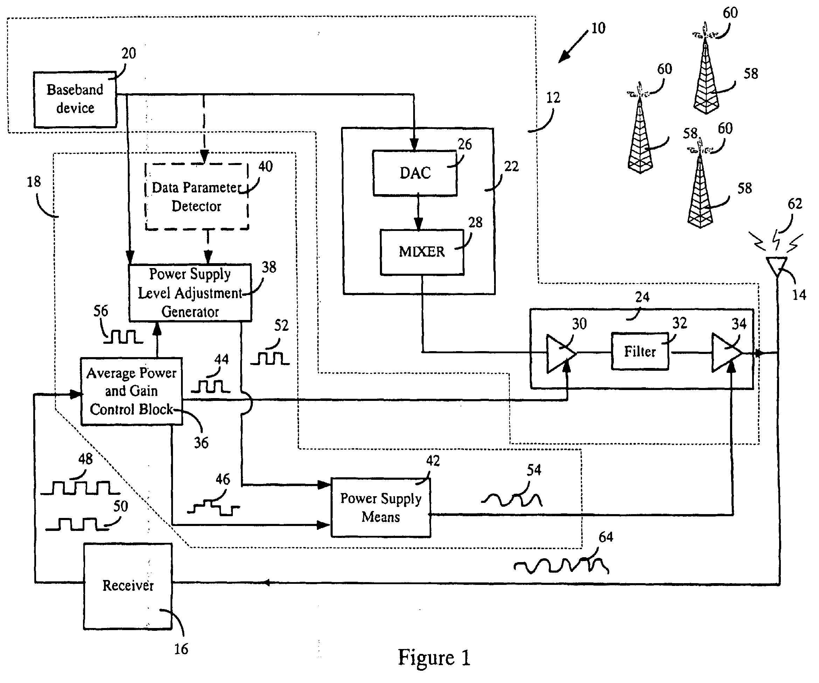

Reference is first made to Figure 1, which shows a block diagram of a wireless communications device **10** having a data transmission block **12,** an antenna **14,** a receiver **16** and a power management system **18.** The wireless communications device **10** may be any type of wireless communications device, such as an e-mail enabled personal data assistant, a cellular phone, a portable computer, etc. Figure 1 shows a first exemplary embodiment of the power management system **18** according to the invention; other embodiments are shown in later Figures.

The data transmission block **12** includes a baseband device **20,** an up-conversion block **22,** and an output power amplification block **24.** The up-conversion block **22** includes a digital-to-analog converter (DAC) **26** and a mixer **28.** The output power amplification block **24** includes a pre-amplifier **30,** a filter **32** (which is optional), and a power amplifier **34.** The pre-amplifier **30** and the filter **32** implement the pre-amplification stage and the power amplifier **34** implements the power amplification stage. The receiver **16** includes a power control data detector, as is commonly known to those skilled in the art, for providing power control information for the output power amplification block **24.**

The power management system **18** includes an average power and gain control block **36,** a power supply level adjustment generator **38,** a data parameter detector **40** (which is optional), and a power supply means **42.** The average power and gain control block **36** provides a gain control signal **44** to the pre-amplifier **30** and an average desired transmit power signal **46** to the power supply means **42.** The gain control signal **44** is provided to the pre-amplifier **30** to control the gain of the pre-amplifier **30.** The average desired transmit power signal **46** is generated based on at least one of a power control instruction signal **48** and a received signal strength indicator signal **50** that is provided by the receiver **16** based on signals received by the wireless communications device **10.** The power supply means **42** also receives a power supply level adjustment signal **52** from the power supply level adjustment generator **38** and combines the average desired transmit power signal **46** and the power supply level adjustment signal **52** to provide a variable power supply signal **54** to the power amplifier **34.** Preferably, this operation is in response to input changes including the power control instruction signal **48** which is updated every 1.25 ms. The power supply level adjustment generator **38** determines the additional adjustment provided by the power supply level adjustment signal **52** based on the data type and data rate of the data that is to be transmitted by the communications device **10.** The power supply level adjustment signal **52** can also preferably varied according to other parameters such as environmental parameters and the like that are described in further detail below.

The wireless communication device **10** communicates with remote base stations **58** and other devices through radio signals transmitted and received by the antenna **14.** The base stations **58** transmit base station radio signals **60** that are received by the antenna **14** and processed by the receiver **16** to extract data from them, as is further described below. This data path may be referred to as the forward link. The wireless communications device **10** also transmits wireless device radio signals **62** to the base stations **58** from the antenna **14.** The data path that begins at the wireless communications device **10** and ends at the base stations **58** may be referred to as the reverse link.

In the forward link, the antenna **14** detects and receives one of the base station radio signals **60** and provides a received signal **64** to the receiver **16.** The receiver **16** will typically include several functional blocks, as is commonly known to those skilled in the art, to convert the received signal **64** into a digital signal and to process the received signal **64** to remove noise, to perform down-conversion or demodulation, and the like. In many communications systems, including the IS-95 Code Domain Multiple Access (CDMA) standard and subsequent communications standards, the base stations **58** may transmit a series of power control instructions in the power control instruction signal **48** as part of the received signal **64.** The power control instruction signal **48** instructs the power management system **18** to increase or decrease the power of the transmitted wireless device radio signals **62.** In one standard, the power control instruction signals **48** are sent in the form of data bits and may be received at a rate of 800 power control bits per second. One of the base stations **58** will send the power control instruction signal **48** based on the quality of the wireless device radio signals **62** received by the base station **58** from the wireless communications device **10**. If the wireless device radio signal **62** is received with sufficient power to allow it to be decoded and used, then the base station **58** may instruct the wireless communications device **10** to maintain or reduce the power of the wireless device radio signal **62.** If the wireless device radio signal **62** is marginal or is too weak to be used, the base station **58** may instruct the wireless communications device **10** to increase the power of the wireless device radio signal **62.** This type of power control is typically referred to as reverse link closed loop power control.

Some wireless communication systems, including systems which operate under the IS-95 CDMA standard and subsequent standards, may also use reverse link open loop power control. Open loop power control is performed by measuring the signal strength of the base station radio signal **60** received by the wireless communications device **10.** If the signal strength of the base station radio signal **60** is high, then it is assumed that the wireless communications device **10** may transmit the wireless device radio signal **62** with lower strength and conversely, if the signal strength of the base station radio signal **62** is low, then it is assumed that the wireless device radio signal **62** must be stronger to reach the base radio station **58** in a usable form. This open loop power control is based on the assumptions that: (i) the base radio station **58** is transmitting the base station radio signal **60** with approximately constant signal strength; and, (ii) the attenuation of the base station radio signal **58** in the forward link will be about the same as the attenuation of the wireless device radio signal **62** in the reverse link.

The embodiments of the invention described herein are configured to operate according to an open and closed loop power control scheme. The embodiments of the invention can be configured to operate according to an open loop power control scheme by having the receiver **16** measure the signal strength of the received signal **64** to provide the received signal strength indicator signal **50.** Accordingly, the received signal strength indicator signal **50** corresponds to the signal strength of the base station radio signal **60.** In this case, the power control instructions can be a combination of the open loop power instructions (derived from the received signal strength indicator signal **50)** and closed loop power control bits that are encoded in the control channel in the received base station radio signals **60.** In the absence of closed loop corrections the power control is based solely on the received signal strength indicator signal **50.**

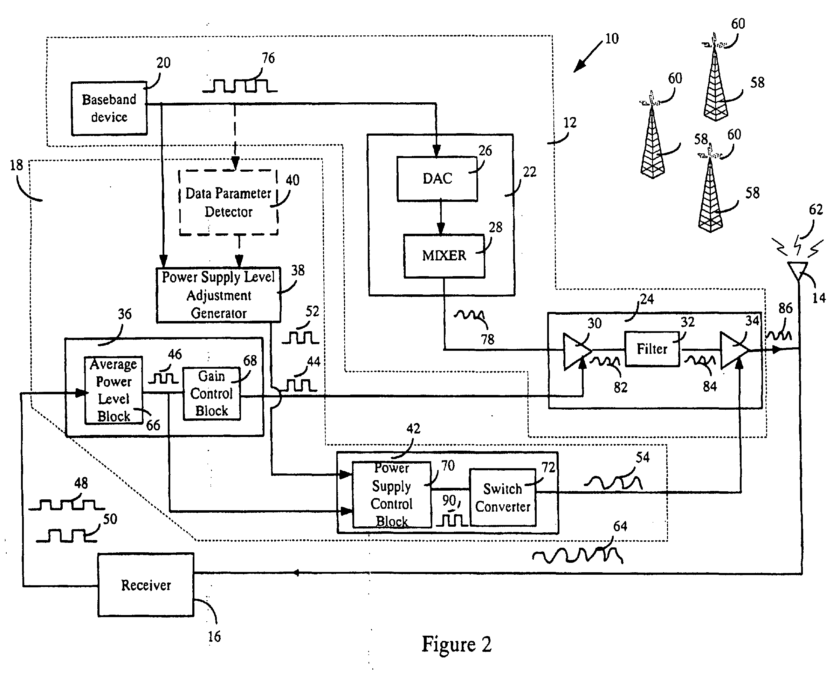

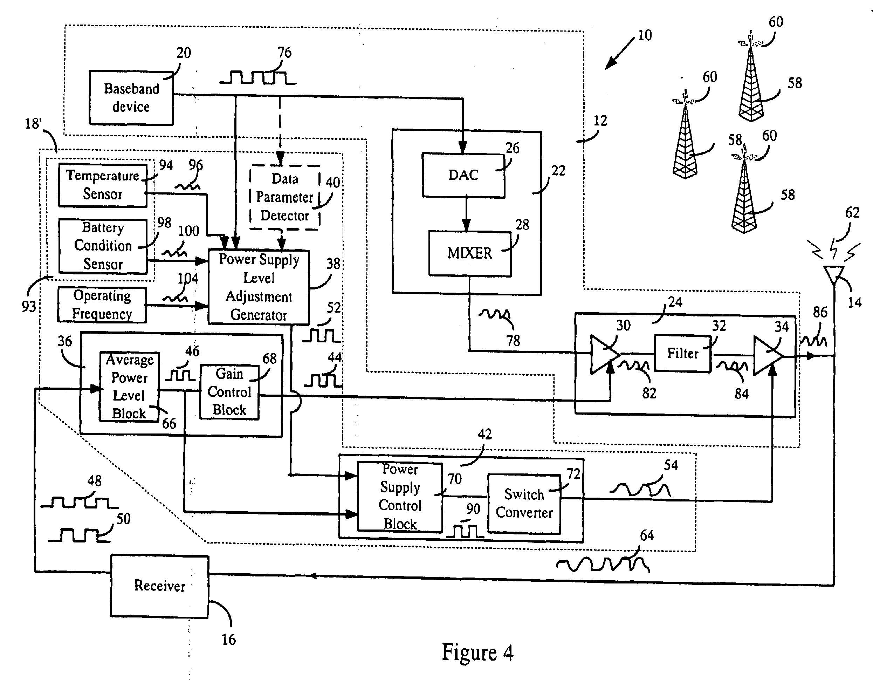

Various detailed embodiments of the power management system **18** that operate according to an open and closed loop power control scheme will now be discussed. Components that are identified with similar numbers in each of the embodiments work in a similar fashion unless otherwise specified. Referring now to Figure 2, the average power and gain control block **36** includes an average power level block **66** and a gain control block **68.** Further, the power supply means **42** includes a power supply control block **70** and a switch converter **72.**

The receiver **16** extracts the power control instruction signal **48** and passes the signal **48** to the average power level block **66.** The receiver **16** also generates the received signal strength indicator signal **50** and passes the signal **50** to the average power level block **66.** The average power level block **66** combines the power control instruction signal **48** and the received signal strength indicator signal **50** to calculate an average desired transmit power signal **46** for the wireless device radio signal **62.** Typically, the received signal strength indicator signal **50** is used to set an initial power level when radio communication is established between the wireless communications device **10** and one of the base stations **58.** As the wireless communications device **10** is moved from place to place, it may communicate with different base stations **58** and a seamless "hand-off" between the base stations **58** is desirable. To facilitate this "hand-off", when the wireless communications device **10** initially begins communicating with a new base station **58,** the average power level block **66** relies on the received signal strength indicator signal **50** to approximate the average desired transmit power signal **46.** During ongoing communication between the wireless communications device **10** and the base stations **58,** the average desired transmit power signal **46** is refined as instructions in the power control instruction signal **48** are received from the base stations **58.** The power control bits are "up" and "down" instructions which are time integrated and added to the open loop power. Over time, the average desired transmit power signal **46** may be refined quite precisely to provide a balance between sufficient power so that the wireless device radio signal **62** may be received by one of the base stations **58** in a usable form (i.e. it is not corrupted or undecodable due to interference from other signals or due to having a low signal strength) and so that the wireless device radio signal **62** does not interfere with other devices communicating with the base station **58** or other communication devices.

The baseband device **20** generates a baseband outgoing data stream **76** to be transmitted to one of the base stations **58.** Depending on the type of service that the baseband device **20** supports, the outgoing data stream **76** may include only one type of data or may have different types of data at different times. For example, some wireless communication devices provide multiple functions including e-mail communication, text messaging, voice communication and other extended services. Different services may use different encoding and modulation methods that have different PAPR characteristics. For example, in CDMA, even low data rate traffic has a high PAPR after data modulation. As the data rate increases, the PAPR increases further. The data parameter detector **40** detects the type of data in the baseband outgoing data stream **76** in real-time and provides the data parameter indication to the power supply level adjustment generator **38.** Alternatively, and more preferably, the data parameter indication can be provided directly to the power supply level adjustment generator **38** by the baseband device **20** in real-time. Hence, the solid arrow connecting the baseband device **20** to the power supply level adjustment generator **38** and the use of dotted lines for the data parameter detector **40** and the corresponding connections. The data parameter indication includes information on the type of data, the data modulation and the data rate in the baseband outgoing data stream **76.**

The baseband outgoing data stream **76** is processed by the up-conversion block **22** to convert it into a corresponding analog output signal **78**. The DAC **26** first converts the baseband outgoing data stream **76** into an analog signal. The analog signal is then mixed with a carrier frequency by the mixer **28** to produce the analog output signal **78** which is now in the radio frequency range rather than the baseband. The mixing may be accomplished in a single step or in multiple steps, depending on the implementation, as is commonly known by those skilled in the art. Filtering may also be used. The carrier frequency is determined by the communications standard under which the wireless communications device **10** operates, which is well understood by those skilled in the art. In addition, it should be noted that many wireless devices, including the exemplary wireless communications device **10,** are capable of transmitting a wireless device radio signal **62** in more than one frequency band, and within more than one channel within each frequency band.

The power supply level adjustment generator **38** uses the data parameter indication of the baseband outgoing data stream **76** to determine the power supply level adjustment signal **52.** In the present embodiment, the power supply level adjustment generator includes a PAPR mapper which may be implemented by a look-up table. The look-up table is a discrete look-up table that is pre-computed by conducting tests on a prototype wireless communication device. Specifically, a value for a data parameter is selected, such as a particular data rate test value, and given a fixed power supply level for the power amplifier **34,** the headroom is observed. A power supply level adjustment value is then selected to reduce the headroom to a minimal level. The adjustment value is then entered into the look-up table and associated with the particular data rate test value. During operation, the data parameter indication (i.e. data type, data rate and data modulation) are then used as indices into the look-up table to look up a value for the power supply level adjustment signal **52**. The power supply level adjustment signal **52** typically has a higher than nominal value if the data type requires a high data bandwidth for transmission. The power level adjustment signal **52** can also be varied based on environmental factors which are described in further detail below. The power level adjustment signal **52** is also adjusted at the upper and lower edges of the frequency band in which the wireless device radio signals **62** are transmitted due to the characteristics of the transmit chain. For exemplary purposes, the power level adjustment signal **52** may range from 0 to 9 dB depending on the data type at a slew rate of 800 dB/second.

Typically, the manufacturer or vendor of the wireless communications device **10** will configure a PAPR mapper in the power supply level adjustment generator **38** to provide suitable values for the power level adjustment signal **52** for different data types, data modulation and data rate as well as other parameters that are further described below. The PAPR mapper is discussed in further detail below. This is accomplished by following a calibration method that is described in further detail below.

In an alternative embodiment of the invention, the PAPR mapper may be implemented using a formula based on the relationship between the various inputs to the power supply level adjustment generator **38** and the corresponding value of the power level adjustment signal **52** rather than using a look-up table.

The average desired transmit power signal **46** is supplied to the gain control block **68,** which converts the average desired transmit power signal **46** into a gain control signal **44.** The gain control block **68** may be implemented as a look-up table that has been calibrated to achieve a desired average transmitted power level at the antenna **14** that is in accordance with the average desired transmit power signal **46**. The look-up table in the gain control block **68** compensates for both non-linearities in the control characteristic of the pre-amplifier **30** and the gain variation of the power amplifier **34** that is caused by the change in the power supply voltage level that is provided to the power amplifier **34.** The content of the look-up table is written during factory calibration of the wireless communications device **10** based on the received signal strength indicator signal **50** and the observed transmitter power at the device's antenna port. Gain values in the look-up table are calculated based on the received signal strength indicator signal **50** which are then offset by the control bits in the power control instruction signal **48.** During operation, linear interpolation can be performed for values within the table.

The pre-amplifier **30** receives the analog output signal **78** and amplifies under the control of the gain control signal **44** to produce a pre-amplified transmission signal **82.** The gain control signal **44** is generated so that an increase or decrease in the average desired transmit power signal **46** produces a log-linear increase or decrease in the amplification of the output power amplifier block **24,** through adjusting the gain of the pre-amplifier **30.**

The pre-amplified transmission signal **82** is filtered by the filter **32** to produce a filtered transmission signal **84.** The filter **32** removes noise that is introduced into the pre-amplified transmission signal **82** by the pre-amplifier **30** and prior stages of the wireless communications device **10.** The specific characteristics of the filter **32** such as the passband frequency range, the filter order and the like, will depend on the specific pre-amplifier **30** and the prior stages that are used in the wireless communications device **10.** A skilled person in the art will be capable of selecting appropriate parameters for the filter **32.** It should be noted that the filter **32** is optional and may be omitted in cases where the pre-amplified transmission signal **82** is sufficiently free of noise.

The filtered transmission signal **84** is amplified by the power amplifier **34** to provide an amplified transmission signal **86.** The amplified transmission signal **86** is transmitted by the antenna **14** as the wireless device radio signal **62.** The amplified transmission signal **86** has sufficient power so that it may be received by any one of the base stations **58** in a form that is receivable and decodable to re-create the baseband outgoing data stream **76**.

The average and peak power levels of the amplified transmission signal **86** vary over time. As the average desired transmit power signal **46** varies, the amplitude of the pre-amplified transmission signal **82** will vary. The power amplifier **34** will typically have a constant gain factor and accordingly, the amplified transmission signal **86** will also have a time-varying average power level. The power amplifier **34** may also have a gain factor that varies with the power supply voltage level, but this variation may be compensated using calibration tables as is well known in the art. When the analog output signal **78** has a high PAPR, the instantaneous power level of the amplified transmission signal **86** will also vary. At any point in time, the power amplifier **34** requires sufficient power to operate its internal electronics and to produce the amplified transmission signal **86.** When the amplified transmission signal **86** has its maximum instantaneous power level (i.e. during a maximum peak of the amplified transmission signal **86** which corresponds with the highest possible value for the average desired transmit power signal **46),** the power amplifier **34** must still have at least some headroom to ensure that the amplified transmission signal **86** is not clipped at its peaks. One reason for the significant power loss that occurs in the output power amplifier block **24** of the wireless communication device **10** is that the amplified transmission signal **86** is rarely at this maximum level and is usually at a much lower power level. The excess headroom between the power supply level provided to the power amplifier **34** and the magnitude of the amplified transmission signal **86** is dissipated as heat.

To avoid this power loss, the power supply level adjustment signal **52** and the average desired transmit power signal **46** are combined by the power supply control block **70** to generate a power control signal **90,** which may be a pulse width modulated or pulse density modulated signal. The power control signal **90** is converted into the variable power supply signal **54,** which is an analog signal, by the switch converter **72.** The variable power supply signal **54** is the source of power supply for the power amplifier **34.** The variable power supply signal **54** has a magnitude such that there is a small, yet sufficient, amount of headroom above the maximum instantaneous power required to produce the amplified transmission signal **86** with a desired quality and for the power amplifier **34** to sufficiently operate its internal electronics. An exemplary value for the required headroom is on the order of 1 to 3 dB. As manufacturing consistency increases for manufacturing the various components of the wireless communications device **10** and the power management system **18,** the headroom can be reduced.

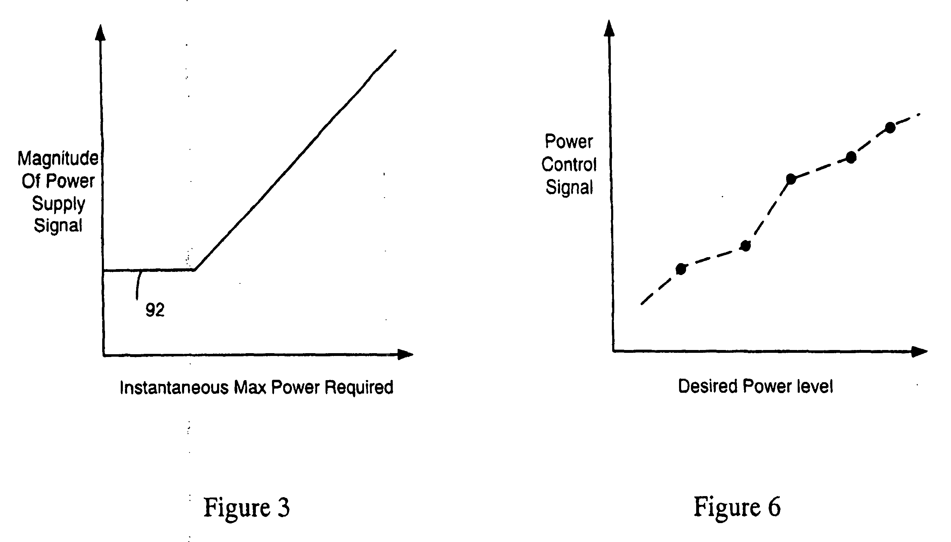

Referring now to Figure 3, shown therein is a graph of an exemplary relationship between the instantaneous maximum power required by the power amplifier **34** to produce the amplified transmission signal **86** and the variable power supply signal **54.** This relationship may vary depending on the implementation of the power managemenent system **18** and the components used in the wireless communications device **10.** The variable power supply signal **54** is generally slightly greater than a minimum voltage level **92** required by the power amplifier **34** at any point in time to produce the amplified transmission signal **86** with a predefined required quality. The variable power supply signal **54** will vary in time, corresponding to changes in the average desired transmit power signal **46** and changes in the data parameter indication of the baseband outgoing data stream **76** being transmitted by the wireless communications device **10.** In another embodiment of the power management system **18,** the variable power supply signal **54** will also preferably vary due to changes in the environment of the wireless communications device **10** (such as temperature), changes in condition of the battery that powers the wireless communications device and changes in the frequency range in which the wireless device radio signal **62** is being transmitted.

As previously mentioned, the variable power supply signal **54** has a minimum voltage level **92,** which is selected to ensure that even when the instantaneous maximum power required by the power amplifier **34** to generate the amplified transmission signal **86** is low, sufficient power is supplied to the power amplifier **34** to keep it stable and to keep its internal electronics functioning. The minimum voltage level **92** may be maintained by the power supply control block **70** (which can maintain the power control signal **90** above the minimum voltage level **92)** or the switch converter **72** which can directly maintain the variable power supply signal **54** above the minimum voltage level **92.** An exemplary range of values for the minimum voltage level is 0.9 to 1.4 Volts depending on the design of the power amplifier **34.**

The power management system **18** reduces the headroom between the level of the variable power supply signal **54** that is supplied to the power amplifier **34** and the supply power required for the power amplifier **34** to generate the amplified transmission signal **86** without clipping. This reduction in headroom reduces the amount of power dissipated in the power amplifier as heat. Overall, the reduced power loss can substantially improve the power efficiency and battery life for the wireless communications device **10,** since one of the largest areas of power loss in many wireless devices is excess power headroom in the power amplifier.

The power management system **18** may be modified in various ways within the scope of the invention. For instance, in some cases, it may be desirable to apply an analog power supply signal to the switch converter **72.** To do so, a DAC may be coupled between the power supply control block **70** and the switch converter **72.** This is done when the switch converter control **72** is analog. In addition, it may be desirable to filter high frequency noise from the variable power supply signal **54,** particularly if a DAC is used to produce an analog power supply signal. This may particularly be required if a delta-sigma converter is used to make the D/A conversion, rather than a linear DAC. The filter in this case may be inserted at the input of the switch converter **72.**

In another alternative embodiment of the invention, it may be desirable to insert a buffer (not shown) to temporally align the variable power supply signal **54** and the filtered transmission signal **84** at the power amplifier **34** (i.e. the supply voltage to the power amplifier **34** is preferably updated at the same rate as the updating of the gain control signal **44).** If the data path between the output of the baseband device **20** and the input of the power supply control block **70** delays the variable power supply signal **54** in comparison to the arrival of the data at the input of the power amplifier **34,** it is possible that at times, the power amplifier **34** may not have sufficient headroom to produce the amplified transmission signal **86.** To synchronize the variable power supply signal **54** and the filtered transmission signal **84,** a data buffer (not shown) may be inserted between the baseband device **20** and the DAC **26,** after the point at which the baseband device **20** is connected to the power management system **18.** The buffer may be configured to introduce an appropriate delay, based on the delay introduced by the various elements of the power management system **18**.

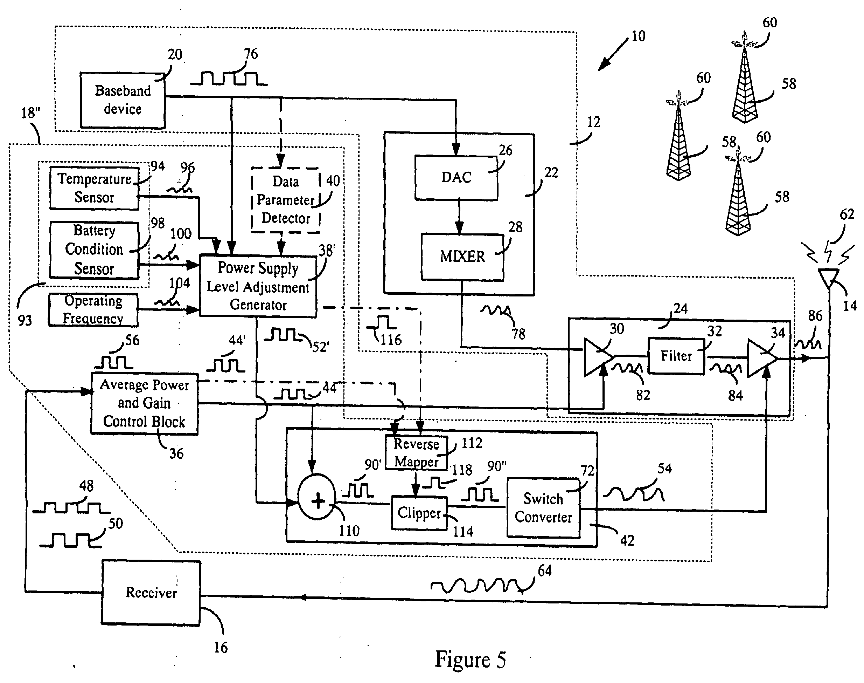

Referring now to Figure 4, shown therein is an alternative embodiment of a power management system **18'** which includes an environmental sensor unit **93** that is connected to the power supply level adjustment generator **38** for providing at least one environmental information signal. The environmental sensor unit **93** includes one or more environmental sensors for sensing variations in parameters that can affect the characteristics of the power amplifier **34** and hence the level of the variable power supply signal **54.** For instance, the level of the variable power supply signal **54** in response to the ambient temperature of the wireless communications device **10,** the condition of the battery that powers the wireless communications device **10** and/or the frequency at which the wireless device radio signal **62** is transmitted.

The environmental sensor unit **93** can include a temperature sensor **94** for sensing the ambient temperate of the hardware of the wireless communications device **10** and provide a temperature information signal **96** to the power supply level adjustment generator **38.** The temperature information signal **96** will preferably be in a digital form. If the temperature sensor **94** provides analog temperature information, an analog-to-digital converter (ADC) may be coupled between the temperature sensor **94** and the power supply level adjustment generator **38** to convert the analog temperature information signal **96** into a digital temperature information signal. The temperature information signal **96** may be passed to the power supply level adjustment generator **38** using shared memory or any other data transfer mechanism commonly known to those skilled in the art.

The environmental sensor unit **93** can include a battery condition sensor **98** for sensing the charge level of the battery that is used to power the wireless communications device **10** to provide a battery condition information signal **100** to the power supply level adjustment generator **38.** As in the case of the temperature sensor **94,** an ADC may be used to convert an analog battery condition information signal into a corresponding digital battery condition information signal. Further, the digital battery condition information signal **100** may be passed to the power supply level adjustment generator **38** using techniques known to those skilled in the art. The battery condition is sensed so that the power supply level of the power amplifier **34** can be increased in the event that the analog output signal **78** that is passing through the output power amplifier block **24** has a high PAPR. In this case, adjustments are made to the power supply level adjustment signal **52** to compensate for the anticipated compression due to the lower charge of the battery.

The environmental sensor unit **93** can also provide a frequency information signal **104** to provide information on the operating (i.e. transmission) frequency of the wireless device radio signals **62** to the power supply level adjustment generator **38.** The operating frequency can be obtained from the baseband device **20** or the up-conversion block **22.** As in the case of the temperature sensor **94** and the battery condition sensor **98,** an ADC may be used to provide the frequency information signal **104** as a corresponding digital frequency information signal.

The power supply level adjustment generator **38** combines the data parameter indication of the baseband outgoing data stream **76** with at least one of the temperature information signal **96,** the battery condition information signal **100** and the frequency information signal **104** to determine the power supply level adjustment signal **52.** In this case, the power supply level adjustment generator **38** can utilize a multi-dimensional look-up table. To reduce complexity a two-dimensional look-up table may be used. The data parameter indication, temperature information signal **96,** battery condition information signal **100** and the frequency information signal **104** are used as indices into the look-up table to look up a value for the power supply level adjustment signal **52.** Alternatively, the content of the look-up table can be updated when there are changes in the operating frequency channel or temperature. The effects of frequency and temperature are used to scale the contents of the two-dimensional look-up table by +/a few dB. In another alternative, there can be a plurality of PAPR mappers, with one PAPR mapper being provided for the temperature information signal, one PAPR mapper being provided for the battery condition information signal and one PAPR mapper being provided for the operating frequency. In this case, the outputs of the PAPR mappers, which are in units of dB, can be added together to obtain the power supply level adjustment signal **52.** Logarithmic combination may be used if the amplitude of the outputs of the PAPR mapper are not in dB. In either case, factory calibration is done to determine the effect of the environmental parameters on the power supply level adjustment value. For instance, the device **10** can be put into an environmental chamber and the temperature adjusted to a certain value to determine the effect on the power supply level adjustment value for a certain data parameter value. With regards to battery condition, the level of the battery of the device **10** can be adjusted to different values to determine the effect on the power supply level adjustment value for a certain data parameter value. With regards to operating frequency, the transmission frequency can be varied to determine the effect on the power supply level adjustment value for a certain data parameter value.

The power supply level adjustment signal **52** is typically larger than a nominal value if (a) the data parameter indicates a high data bandwidth for transmission; (b) the temperature increases; or (c) the charge level of the battery decreases. Collectively, the adjustment due to temperature, battery condition and operating frequency can have a substantial effect on the value of the power supply level adjustment signal **52.**

The power supply level adjustment generator **38** is configured to provide suitable values for the power supply level adjustment signal **52** for different data types, data modulation and data rate as well as environmental information (i.e. temperature and battery), frequency information. The power supply level adjustment signal **52** is typically on the order of +/- 1-3 dB for a temperature variation, +/- 1 dB for battery level variation and +/- 1-3 dB for a transmission frequency variation.

Some embodiments of the invention may be implemented in a power management system **18"** that does not allow access to the average desired transmit power signal **46.** Figure 5 illustrates an alternative embodiment for the power management system **18"** in which the average power and gain control block **36** is implemented as a single block. As a result, the average desired transmit power signal **46** is not available as an input for the power supply means **42.** In addition, the average power and gain control block **36** operates as a hybrid of a lookup table and an interpolator. The power control instruction signal **48** and the received signal strength indicator signal **50** indicate a desired average supply power level as described previously. The average power and gain control block **36** provides the gain control signal **44** in response to the desired average supply power level.

In this case, the power supply means **42** comprises a summer **110.** a reverse mapper **112,** a clipper **114** and the switch converter **72.** The summer **110** receives the gain control signal **44** and an altered version of the power supply level adjustment signal **52'** to provide a first power control signal **90'**. The altered version of the power supply level adjustment signal **52'** is provided by the power supply level adjustment generator **38'** so that the power supply level adjustment signal **52'** can be directly summed with the gain control signal **44.** Typically, the gain control signal **44** has units of Volts and the power supply level adjustment signal **52** has units of dB so that these two signals cannot be directly summed together. Accordingly, the power supply level adjustment generator **38'** scales the power supply level adjustment signal **52** to provide the altered signal **52'.** In particular, the scaling is done based on the generation of the gain control signal **44** in the average power and gain control block **36** which depends on parameters that define the look-up table in the average power and gain control block **36.** These parameters are known prior to the commercial use of the wireless communications device **10** and hence are available for use in the power supply level adjustment generator **38'.**

The first power control signal **90'** is then provided to the clipper **114** which has a positive and negative saturation value and a slope that connects these two values. The clipper **114** operates on the first power control signal **90'** to provide a second power control signal **90"** to the switch converter **72.** The switch converter **72** then generates the variable power supply signal **54** as previously described. A DAC may also be used as described previously.

The clipper **112** may clip the first power control signal **90'** or attenuate/compress the first power control signal **90'** according to the slope, based on the magnitude of the first power control signal **90'.** The positive and negative saturation values and the slope of the clipper **112** can be varied in response to the operation of the power management system **118".** In particular, the look-up table that is used in the average power and gain control block **36** and the environmental information **116** that is provided by the environmental sensor unit **93** via the power supply level adjustment generator **38'** can be used to vary the positive and negative saturation values and the slope of the clipper **112.** In particular, the environmental information **116** and an altered version of the gain control signal **44'** are provided to the reverse mapper **112** which then provides a clipper adjustment signal **118** to the clipper **114.** The contents of the signal **44'** are derived from the data in the look-up table of block **36.** The connection lines are shown as dash-dotted lines since the adjustment of the clipper due to the signals **44** and **116** occurs at a slower rate compared to the rate of change of the power supply level adjustment signal **52'.** In particular, the modification occurs when there is a change in the look-up table used in block **36** or when there is a substantial change in the environmental information **116** (i.e. there is a drastic change in temperature or a hand-off in transmission frequency). For instance, the maximum saturation value is related to operating frequency. The clipper **114** is modified in this fashion to optimize the variable power supply signal **54** and hence the power savings in the power amplifier **34.** The summer **110,** clipper **114** and the switch converter **72** are preferably implemented via hardware and the reverse mapper **112** is preferably implemented via software, although other implementations for these blocks is possible.

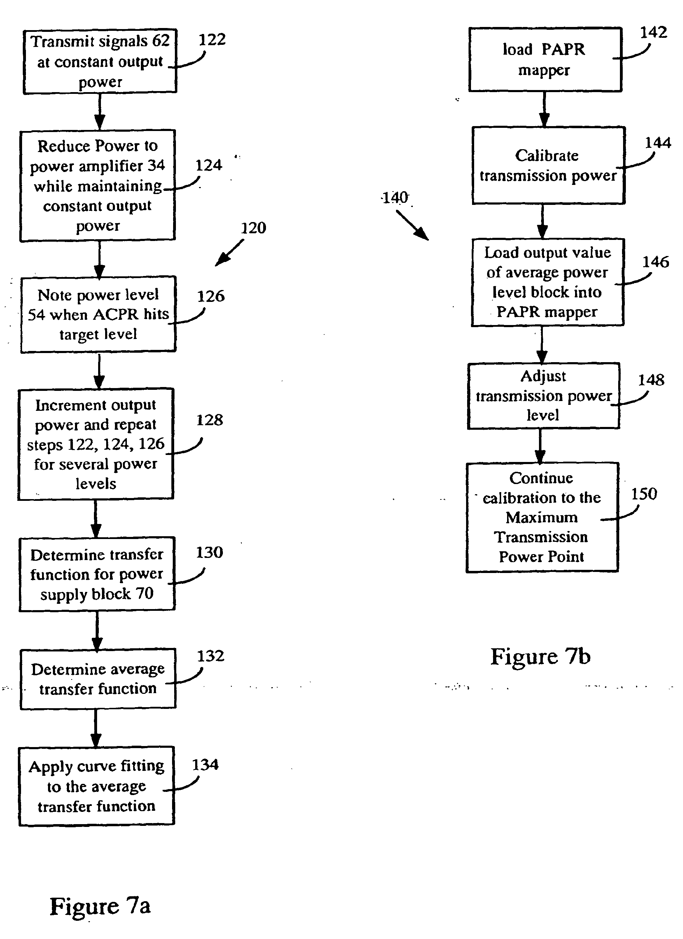

Figure 6 illustrates the operation of the average power and gain block **36.** As the average desired power supply level rises and falls, the average power and gain control block **36** either selects a pre-determined value (identified by solid dots) or interpolates between pre-determined values to calculate a value for gain control signal **44.** Preferably, the average power and gain control block selects the closest pre-determined value when generating the gain control value **44** to avoid interpolation errors. In practice, the range associated with Figure 6 is about -52 to 26 dBm. The pre-determined values are programmed into the average power and gain block **36** by a manufacturer, vendor or operator of the wireless communications device **10.**

The power management system **18"** provides a practical implementation of the invention that may be used with commercially available baseband chipsets in a device in which the average desired transmit power signal **46** is not available as an input to the power supply means **42**.

In each of the embodiments of the invention shown herein, the PAPR mapper may provide a value for the power supply level adjustment signal every 20 ms. In some cases, a value for the power supply level adjustment signal may be provided every 5 ms. Further, in some cases, it is preferable to update the supply voltage of the power amplifier **34** every 1.25 ms to guarantee that the ACPR (adjacent channel power ratio) limits are never violated. In addition, the mapping that is performed by the power supply level adjustment generator **38** is such that the transition from a low power supply voltage to a high power supply voltage for the power amplifier **34** is a consistent and smooth function of the desired average power level to reduce non-linearities that are introduced by the various embodiments of the power management system **18.**

As shown in Figure 3, the power supply control block **70** applies a linear transformation to a combination of the average desired transmit power signal **46** and the power supply level adjustment signal **52.** The transformation is applied via a look-up table or via an equation. The equation can be implemented in software or hardware. The exact shape of the transformation is adjusted to tune performance and production yield. Accordingly, the power supply control block **70** is preferably calibrated before use.

Referring now to Figure 7a, shown therein is a flowchart showing the steps of a power supply block calibration method **120.** The calibration is done at a given reference temperature, and a given reference battery condition that are arbitrarily chosen. The baseband device **20** is configured to transmit at an arbitrarily chosen reference transmission frequency. The power supply level adjustment value generator **38** is then configured such that the contributions from the reference temperature, reference battery condition and reference frequency is set to zero. The first step **122** of the calibration method is to transmit the wireless device radio signals **62** at a constant power level while the ACPR is monitored. The next step **124** is to reduce the magnitude of the variable power supply signal **54** to the power amplifier **34** while maintaining constant output power in the wireless device radio signals **62.** This is done by increasing the input drive to the power amplifier **34** as the supply voltage to the power amplifier **34** is decreased to maintain constant output power. The next step **126** is to note the magnitude of the variable power supply level signal **54** when the ACPR has increased to a pre-specified design target. The ACPR is defined as the ratio of the power at 1.25MHz offset within a 30kHz bandwidth to the power in the carrier. As the linearity of the power amplifier **34** is reduced by starving its power supply the compression artifacts increase. The next step **128** in the calibration method **120** is to increase the output power of the wireless device radio signals **62** and to repeat steps **122, 124** and **126.** The step size that is used to determine the next power level depends on the implementation of the power amplifier **34** and those skilled in the art will understand how to select the step size. Step **128** is repeated for several output-power levels. The number of output power levels that are used for calibration depends on the implementation of the power amplifier. Typically, three, well-spaced output power levels can be used for calibration.

The next step **130** is to use the control curves of the switching converter **72** and the minimum voltage level **92** to compute an ideal transfer function that is required to derive the digital power signal **90** for controlling the switch converter **72.** The ideal transfer function is related to the look-up table used in the average power and gain control block **36** or the gain control block **68.** The construction of the look-up table was previously described. The next step **132** is to repeat steps **122** to **130** for several different wireless communication devices to obtain an average transfer function.

The next step **134** is to perform curve fitting on the average transfer function. One way to accomplish this is by fitting a linear line to the average transfer function by adjusting the slope and the intercept of the straight line to fit the average transfer function with minimal error. The slope that is determined is used by the power supply control block **70** as one of the parameters for varying the power supply bias voltage, the ramp slope or the idle bias current. The intercept is set by the breakeven power of the output amplifier block **24** which is the point at which further reduction in the variable power supply signal **54** to the power amplifier **34** (and consequently gain) causes the earlier stages in the output amplifier block **24** to use so much additional power that the total power consumption of the wireless communications device **10** is increased. The intercept coincides with the minimum voltage level **92**. The parameters determined by curve fitting is then used to create a look-up table for the power supply block **70.**

Referring now to Figure 7b, shown therein is a flowchart showing the steps of a power supply level adjustment generator calibration method **140.** The calibration method **140** is preferably performed on a per device basis during factory calibration to account for variations in production tolerance and deviations from the average transfer function model that was obtained for the power supply control block **70.** The first step **142** of the calibration method **140** is to load the power supply adjustment level generator **38** with a value that causes the switching converter **72** to operate at its minimum output voltage. This allows the calibration method **140** to start at the lowest transmission power point of the wireless communications device **10.**

The next step **144** is to calibrate the transmission power using the usual procedure according to the transmission power point defined in step **142.** The usual procedure involves increasing the automatic gain control of the device **10** over a predefined "safe" range and recording the transmitter output power. Preferably, half of the range is calibrated first. This is done until the output power of the wireless communications device slightly exceeds a target power as determined for the set supply voltage. The target power is obtained during characterization of the wireless communication device **10** as is commonly known to those skilled in the art. The characterization will depend on the manufacturer of the components of the output power amplifier block **24.** The target power is the breakeven point that is determined by reducing the power supply level to the power amplifier **34** and determining the point at which the pre-drive circuitry consumes so much power that the savings in power amplifier power dissipation (by reducing headroom) is mitigated.

The next step **146** is to interpolate the output value of the average power and gain control block **36** and load this interpolated output value, after appropriate adjustment by the reverse mapper **112,** into the power supply level adjustment generator **38.** The next step **148** is to adjust the transmission power level to a value that is slightly below the target power.

The next step **150** is to increase the value of the transmission power level and repeat steps **142** to **148** of the calibration method **140.** The calibration method **140** is continually repeated until a maximum specified transmission power point is reached. [0071]The invention has been described here by way of example only. Various modification and variations may be made to these exemplary embodiments without departing from the scope of the invention, which, is limited only by the appended claims.

## Claims

1. A power management system (18") for providing a variable power supply signal (54) to an output power amplifier block (24) in a wireless communication device (10), the power management system (18") comprising:
an average power and gain control block (36) for providing a gain control signal (44) in response to at least one of a power control instruction signal (48) and a received signal strength indicator signal (50) and providing the gain control signal (44) to the output power amplifier block (24);
an environmental sensor unit (93) for providing at least one environmental information signal (96, 100, 104);
a power supply level adjustment generator (38') connected to the environmental sensor unit (93) for providing an altered version of a power supply level adjustment signal (52') in response to a data parameter indication of a baseband outgoing data stream (76) to be transmitted by the wireless communication device (10) and the at least one environmental information signal (96, 100, 104); and,
a power supply means (42) connected to the average power and gain control block (36) and the power supply level adjustment generator (38'), the power supply means (42) provides the variable power supply signal (54) to the output power amplifier block (24) by providing a first power control signal (90') based on the gain control signal (44') and the altered version of the power supply level adjustment signal (52'), clipping the first power control signal (90') to provide a second power control signal (90") and generating the variable power supply signal (54) based on the second power control signal (90"),
wherein, the gain control signal (44) is adapted for applying sufficient gain to a transmission signal version (78) of the baseband outgoing data stream (76) and the altered version of the power supply level-adjustment signal (52') is adapted for providing a small sufficient amount of headroom to efficiently provide power to transmit the transmission signal (78).

2. The power management system (18") of claim 1, wherein positive and negative saturation values and slope used in clipping are adjusted based on the at least one environment signal (96, 100, 104) and the altered version of the gain control signal.

3. The power management system (18") of any one of claims 1 to 2, wherein the average power and gain control block (36) provides an altered version of the gain control signal (44') and the power supply means (42) comprises:
a summer (110) connected to the average power and gain control block (36) and the power supply level adjustment generator (38') for summing the gain control signal (44) and the altered version of the power supply level adjustment signal (52') to generate the first power control signal (90');
a clipper (114) connected to the summer (110) for receiving the first power control signal (90') and generating the second power control signal (90");
a switch converter (72) connected to the clipper (114) for receiving the second power control signal (90") and generating the variable power supply signal (54); and,
a reverse mapper (112) connected to the power supply level adjustment generator (38') and the average power and gain control block (36) for receiving an environmental signal (116) and the altered version of the gain control signal (44') respectively and generating a clipper adjustment signal (118), the reverse mapper (112) also being connected to the clipper (114) for providing the clipper adjustment signal (118) to the clipper (114) for adjusting the positive and negative saturation values and slope of the clipper (114).

4. The power management system (18") of any one of claims 1 to 3, wherein the environmental sensor unit (93) comprises any one or a combination of:
a temperature sensor (94) for providing a temperature information signal (96) as part of the at least one environmental information signal (96, 100, 104), the temperature information signal (96) being related to the temperature of the hardware of the wireless communications device (10); and,
a battery condition sensor (98) for providing a battery condition information signal (100) as part of the at least one environmental information signal (96, 100, 104), the battery condition information signal (100) being related to a battery used to power the wireless communication device (10).

5. The power management system (18") of any one of claims 1 to 4, wherein the at least one environmental information signal (96, 100, 104) comprises a frequency information signal (104) related to the frequency at which the baseband outgoing data stream (76) will be transmitted.

6. The power management system (18") of any one of claims 1 to 5, wherein the power supply means (42) is configured to maintain the variable power supply signal (54) above a minimum voltage level.

7. The power management system (18") of any one of claims 1 to 6, wherein the power supply level adjustment generator (38') is implemented by a plurality of look-up tables, wherein one look-up table is provided for each environmental information signal (96, 100, 104) and the data parameter indication, and the outputs of each look-up table are combined to generate the altered version of the power supply level adjustment signal ( 52).

8. The power management system (18") of claim 7, wherein at least one of the look-up tables is implemented by a corresponding formula.

9. The power management system (18") of any one of claims 1 to 8, wherein the system (18") further comprises a data parameter detector (40) connected to the power supply level adjustment generator (38') and a baseband device (20) of the wireless communications device (10), wherein the data parameter detector (40) provides the data parameter indication.

10. The power management system (18") of claim 1, wherein the power supply block (42) is calibrated by:
i) transmitting the wireless device radio signals (62) at a constant power level from the wireless communication device (10) while monitoring an Adjacent Channel Power Ratio (ACPR);
ii) reducing the magnitude of the variable power supply signal (54) while maintaining constant output power in the wireless device radio signals (62);
iii) recording the magnitude of the variable power supply signal (54) when the ACPR has increased to a pre-specified design target;
iv) increasing the output power of the wireless device radio signals (62) and repeating steps (i) to (iii) for several output power levels; and,
v) computing an ideal transfer function for deriving the power control signal (90) for controlling the switch converter.

11. The power management system (18") of claim 10, wherein the power supply block (42) is further calibrated by:
repeating steps (i) to (v) for several different wireless communication devices (10) to obtain an average transfer function; and,
performing curve fitting on the average transfer function.

12. The power management system (18") of claim 10, wherein the power supply level adjustment generator (38') is calibrated by:
viii) loading the power supply level adjustment generator (38') with a value which causes the output power amplifier block (24) to operate at a lowest transmission power point;
ix) calibrating the transmission power until the output power of the output power amplifier block (24) slightly exceeds a target power determined for a power supply voltage level;
x) interpolating the output value of the average power level block and loading this interpolated output value, after adjustment by a reverse mapper, into the power supply level adjustment generator (38);
xi) adjusting the transmission power level to a value slightly below the target power; and,
xii) increasing the value of the transmission power level and repeating steps (viii) to (xi) until a maximum specified transmission power point is reached.

13. A method of supplying a variable power supply signal (54) to an output power amplifier block (24) in a wireless communications device (10) that receives an incoming data stream (64) from a base station radio signal (60) and transmits an outgoing data stream (76) in a wireless device radio signal (62), the method comprising:
a) detecting at least one of a signal strength of the base station radio signal (60) to produce a received signal strength indicator signal (48), and a power control instruction signal (50) in the base station radio signal (60);
b) generating as an output a gain control signal (44) in response to at least one of the received signal strength indicator signal (48) and the power control instruction signal (50);
c) generating at least one environmental information signal (96, 100, 104) for obtaining information about the environment of the wireless communications device (10);
d) generating an altered version of a power supply level adjustment signal (52') based on a data parameter indication of a baseband outgoing data stream (76) and the at least one environmental information signal (96, 100, 104);
e) providing a first power control signal (90') based on the gain control signal (44) and the altered version of the power supply level adjustment signal (52'), clipping the first power control signal (90') to provide a second power control signal (90"), and generating the variable power supply signal (54) based on the second power control signal (90"); and,
f) providing the variable power supply signal (54) and the gain control signal (44) to the output power amplifier block (24),
wherein, the gain control signal (44) is adapted for applying sufficient gain to a transmission signal version (78) of the baseband outgoing data stream (76) and the altered version of the power supply level adjustment signal (52') is adapted for providing a small sufficient amount of headroom to efficiently provide power to transmit the transmission signal (78).

14. The method of claim 13, wherein (e) comprises
adding the altered version of the power supply level adjustment signal (52') and the gain control signal (44) to provide the first power control signal (90'), the altered version of the power supply level adjustment signal (52') being generated based on the derivation of the gain control signal (44').

15. The method of claim 14, wherein (e) comprises generating an altered version of the gain control signal (44') and providing a clipper adjustment signal (118) to adjust positive and negative saturation values and slope used in clipping, the clipper adjustment signal (118) being generated in response to a combination of the at least one environmental information signal (96, 100, 104) and the altered version of the gain control signal (44').

16. The method of any one of claims 13 to 15, wherein (c) comprises at least one of:
generating a temperature information signal (96) related to the temperature of the hardware of the wireless communications device (10) and providing the temperature information signal (96) as part of the at least one environmental information signal (96, 100, 104);
generating a battery condition information signal, (100) related to a battery used to power the wireless communications device (10) and providing the battery condition information signal (100) as part of the at least one environmental information signal (96, 100, 104); and,
generating a frequency information signal (104) related to the frequency at which the outgoing data stream is transmitted and providing the frequency information signal (104) as part of the at least one environmental information signal (96, 100, 104).

17. The method of any one of claims 13 to 16, wherein the method further comprises maintaining the variable power supply signal (54) above a minimum voltage level.

18. A wireless communications device (10) comprising the power management system (18') of any of claims 1 to 12.

19. A computer readable medium comprising code means executable by a processor of the device (10) of claim 18 for implementing the method of any of claims 13 to 17.

## Patentansprüche

1. Leistungsverwaltungssystem (18") zum Bereitstellen eines variablen Stromversorgungssignals (54) an einen Ausgangsleistungsverstärkerblock (24) in einem Funkübertragungsgerät (10), wobei das Leistungsverwaltungssystem (18") umfasst:
einen Durchschnittsleistungs- und Verstärkungsregelungsblock (36) zur Bereitstellung eines Verstärkungsregelungssignals (44) als Antwort auf mindestens ein Leistungsregelungsbefehlssignal (48) und ein Empfangssignalstärkeanzeigesignal (50) und zur Bereitstellung des Verstärkungsregelungssignals (44) an den Ausgangsleistungsverstärkerblock (24);
eine Umgebungssensoreinheit (93) zur Bereitstellung mindestens eines Umgebungsinformationssignals (96, 100, 104);
einen mit der Umgebungssensoreinheit (93) verbundenen Stromversorgungspegeleinstellungsgenerator (38') zur Bereitstellung einer veränderten Version eines Stromversorgungspegeleinstellungssignals (52') als Antwort auf eine Datenparameteranzeige eines Basisbandausgangsdatenstroms (76), der von dem Funkübertragungsgerät (10) übertragen werden soll, und das mindestens eine Umgebungsinformationssignal (96, 100, 104); und
eine Stromversorgungseinrichtung (42), die mit dem Durchschnittsleistungs- und Verstärkungsregelungsblock (36) und dem Stromversorgungspegeleinstellungsgenerator (38') verbunden ist, wobei die Stromversorgungseinrichtung (42) das variable Stromversorgungssignal (54) dem Ausgangsleistungsverstärkerblock (24) bereitstellt, indem ein erstes Leistungsregelungssignal (90') basierend auf dem Verstärkungsregelungssignal (44') und der veränderten Version eines Stromversorgungspegeleinstellungssignals (52') bereitgestellt wird, das erste Leistungsregelungssignal (90') begrenzt wird, um ein zweites Leistungsregelungssignal (90") bereitzustellen, und basierend auf dem zweiten Leistungsregelungssignal (90") das variable Stromversorgungssignal (54) generiert wird,
**dadurch gekennzeichnet, dass** das Verstärkungsregelungssignal (44) für die Anwendung einer ausreichenden Verstärkung auf eine Übertragungssignalversion (78) des Basisbandausgangsdatenstroms (76) angepasst ist und die veränderte Version des Stromversorgungspegeleinstellungssignals (52') für die Bereitstellung eines kleinen ausreichenden Betrags an Aussteuerungsreserve angepasst ist, um eine effiziente Bereitstellung von Leistung zur Übertragung des Übertragungssignals (78) zu bewirken.

2. Leistungsverwaltungssystem (18") entsprechend Anspruch 1, **dadurch gekennzeichnet, dass** die positiven und negativen Sättigungswerte und die Steilheit, die zur Begrenzung verwendet werden, basierend auf dem mindestens einen Umgebungssignal (96, 100, 104) und der veränderten Version des Verstärkungsregelungssignals eingestellt werden.

3. Leistungsverwaltungssystem (18") entsprechend jedem der Ansprüche 1 bis 2, **dadurch gekennzeichnet, dass** der Durchschnittsleistungs- und Verstärkungsregelungsblock (36) eine veränderte Version des Verstärkungsregelungssignals (44') bereitstellt und die Stromversorgungseinrichtung (42) umfasst:
einen mit dem Durchschnittsleistungs- und Verstärkungsregelungsblock (36) und dem Stromversorgungspegeleinstellungsgenerator (38') verbundenen Summierer (110) zum Summieren des Verstärkungsregelungssignals (44) und der veränderten Version des Stromversorgungspegeleinstellungssignals (52'), um das erste Leistungsregelungssignal (90') zu generieren;
einen mit dem Summierer (110) verbundenen Begrenzer (114) zum Empfangen des ersten Leistungsregelungssignals (90') und zum Generieren des zweiten Leistungsregelungssignals (90");
einen mit dem Begrenzer (114) verbundenen Schaltkonverter (72) zum Empfangen des zweiten Leistungsregelungssignals (90") und zum Generieren des variablen Stromversorgungssignals (54); und
einen mit dem Stromversorgungspegeleinstellungsgenerator (38') und dem Durchschnittsleistungs- und Verstärkungsregelungsblock (36) verbundenen Umkehr-Mapper (112) zum Empfangen eines Umgebungssignals (116) bzw. der veränderten Version des Verstärkungsregelungssignals (44') und zum Generieren eines Begrenzereinstellungssignals (118), wobei der Umkehr-Mapper (112) außerdem mit dem Begrenzer (114) verbunden ist, um dem Begrenzer (114) das Begrenzereinstellungssignal (118) für die Einstellung der positiven und negativen Sättigungswerte und der Steilheit des Begrenzers (114) bereitzustellen.

4. Leistungsverwaltungssystem (18") entsprechend jedem der Ansprüche 1 bis 3, **dadurch gekennzeichnet, dass** die Umgebungssensoreinheit (93) eines der folgenden Elemente oder eine Kombination der folgenden Elemente umfasst:
einen Temperatursensor (94) zum Bereitstellen eines Temperaturinformationssignals (96) als Bestandteil des mindestens einen Umgebungsinformationssignals (96, 100, 104), wobei das Temperaturinformationssignal (96) im Zusammenhang mit der Temperatur der Hardware des Funkübertragungsgeräts (10) steht; und
einen Batteriezustandssensor (98) zum Bereitstellen eines Batteriezustandsinformationssignals (100) als Bestandteil des mindestens einen Umgebungsinformationssignals (96, 100, 104), wobei das Batteriezustandsinformationssignal (100) im Zusammenhang mit einer Batterie steht, die zur Stromversorgung des Funkübertragungsgeräts (10) verwendet wird.

5. Leistungsverwaltungssystem (18") entsprechend jedem der Ansprüche 1 bis 4, **dadurch gekennzeichnet, dass** das mindestens eine Umgebungsinformationssignal (96, 100, 104) ein Frequenzinformationssignal (104) umfasst, das im Zusammenhang mit der Frequenz steht, mit der der Basisbandausgangsdatenstrom (76) übertragen wird.

6. Leistungsverwaltungssystem (18") entsprechend jedem der Ansprüche 1 bis 5, **dadurch gekennzeichnet, dass** die Stromversorgungseinrichtung (42) so konfiguriert ist, dass das variable Stromversorgungssignal (54) über einem minimalen Spannungspegel gehalten wird.

7. Leistungsverwaltungssystem (18") entsprechend jedem der Ansprüche 1 bis 6, **dadurch gekennzeichnet, dass** der Stromversorgungspegeleinstellungsgenerator (38') durch eine Vielzahl von Verweistabellen implementiert wird, wobei jeweils eine Verweistabelle für jedes einzelne Umgebungsinformationssignal (96, 100, 104) und die Datenparameteranzeige bereitgestellt wird und die Ausgaben der einzelnen Verweistabellen kombiniert werden, um die veränderte Version des Stromversorgungspegeleinstellungssignals (52') zu generieren.

8. Leistungsverwaltungssystem (18") entsprechend Anspruch 7, **dadurch gekennzeichnet, dass** mindestens eine der Verweistabellen durch eine korrespondierende Formel implementiert wird.

9. Leistungsverwaltungssystem (18") entsprechend jedem der Ansprüche 1 bis 8, **dadurch gekennzeichnet, dass** das System (18") außerdem einen Datenparameterdetektor (40) umfasst, der mit dem Stromversorgungspegeleinstellungsgenerator (38') und einem Basisbandgerät (20) des Funkübertragungsgeräts (10) verbunden ist, wobei der Datenparameterdetektor (40) die Datenparameteranzeige bereitstellt.

10. Leistungsverwaltungssystem (18") entsprechend Anspruch 1, **dadurch gekennzeichnet, dass** der Stromversorgungsblock (42) durch folgende Schritte kalibriert wird:
i) Übertragen der Funkgerätfunksignale (62) bei einem konstanten Leistungspegel vom Funkübertragungsgerät (10) bei gleichzeitigem Überwachen eines ACPR (Adjacent Channel Power Ratio);
ii) Reduzieren der Größe des variablen Stromversorgungssignals (54) bei gleichzeitiger Beibehaltung einer konstanten Ausgangsleistung in den Funkgerätfunksignalen (62);
iii) Aufzeichnen der Größe des variablen Stromversorgungssignals (54), wenn sich das ACPR auf ein vorgegebenes Konstruktionsziel erhöht hat;
iv) Erhöhen der Ausgangsleistung der Funkgerätfunksignale (62) und Wiederholen der Schritte (i) bis (iii) für verschiedene Ausgangsleistungspegel; und
v) Berechnen einer idealen Übertragungsfunktion zum Ableiten des Leistungsregelungssignals (90) zur Regelung des Schaltkonverters.

11. Leistungsverwaltungssystem (18") entsprechend Anspruch 10, **dadurch gekennzeichnet, dass** der Stromversorgungsblock (42) des Weiteren durch folgende Schritte kalibriert wird:
Wiederholen der Schritte (i) bis (v) für mehrere verschiedene Funkübertragungsgeräte (10) zum Ermitteln einer durchschnittlichen Übertragungsfunktion; und
Durchführen der Kurvenanpassung entsprechend der durchschnittlichen Übertragungsfunktion.

12. Leistungsverwaltungssystem (18") entsprechend Anspruch 10, **dadurch gekennzeichnet, dass** der Stromversorgungspegeleinstellungsgenerator (38') durch folgende Schritte kalibriert wird:
viii) Laden des Stromversorgungspegeleinstellungsgenerators (38') mit einem Wert, der den Ausgangsleistungsverstärkerblock (24) dazu bringt, bei einem niedrigsten Übertragungsleistungspunkt zu arbeiten;
ix) Kalibrieren der Übertragungsleistung, bis die Ausgangsleistung des Ausgangsleistungsverstärkerblocks (24) eine Zielleistung geringfügig übersteigt, die für einen Stromversorgungsspannungspegel bestimmt wurde;
x) Interpolieren des Ausgangswerts des Durchschnittsleistungspegelblocks und Laden dieses interpolierten Ausgangswerts, nach Einstellung durch einen Umkehr-Mapper, in den Stromversorgungspegeleinstellungsgenerator (38);
xi) Einstellen des Übertragungsleistungspegels auf einen Wert geringfügig unterhalb der Zielleistung; und
xii) Erhöhen des Werts des Übertragungsleistungspegels und Wiederholen der Schritte (viii) bis (xi), bis ein festgelegter maximaler Übertragungsleistungspunkt erreicht ist.

13. Verfahren zum Bereitstellen eines variablen Stromversorgungssignals (54) an einen Ausgangsleistungsverstärkerblock (24) in einem Funkübertragungsgerät (10), das einen Eingangsdatenstrom (64) von einem Basisstationsfunksignal (60) empfängt und einen Ausgangsdatenstrom (76) in einem Funkgerätfunksignal (62) überträgt, wobei das Verfahren die folgenden Schritte umfasst:
a) Erkennen von mindestens einer Signalstärke des Basisstationsfunksignals (60) zum Produzieren eines Empfangssignalstärkeindikatorsignals (48) und eines Leistungsregelungsbefehlssignals (50) im Basisstationsfunksignal (60);
b) Generieren eines Verstärkungsregelungssignals (44) als Ausgang als Antwort auf mindestens eines der Empfangssignalstärkeindikatorsignale (48) und das Leistungsregelungsbefehlssignal (50);
c) Generieren mindestens eines Umgebungsinformationssignals (96, 100, 104) zum Ermitteln von Informationen über die Umgebung des Funkübertragungsgeräts (10);
d) Generieren einer veränderten Version eines Stromversorgungspegeleinstellungssignals (52') basierend auf einer Datenparameteranzeige eines Basisbandausgangsdatenstroms (76) und dem mindestens einen Umgebungsinformationssignal (96, 100, 104);
e) Bereitstellen eines ersten Leistungsregelungssignals (90') basierend auf dem Verstärkungsregelungssignal (44) und der veränderten Version des Stromversorgungspegeleinstellungssignals (52'), Begrenzen des ersten Leistungsregelungssignals (90'), um ein zweites Leistungsregelungssignal (90") bereitzustellen, und Generieren des variablen Stromversorgungssignals (54) basierend auf dem zweiten Leistungsregelungssignal (90"); und
f) Bereitstellen des variablen Stromversorgungssignals (54) und des Verstärkungsregelungssignals (44) für den Ausgangsleistungsverstärkerblock (24),
**dadurch gekennzeichnet, dass** das Verstärkungsregelungssignal (44) für die Anwendung einer ausreichenden Verstärkung auf eine Übertragungssignalversion (78) des Basisbandausgangsdatenstroms (76) angepasst ist und die veränderte Version des Stromversorgungspegeleinstellungssignals (52') für die Bereitstellung eines kleinen ausreichenden Betrags an Aussteuerungsreserve angepasst ist, um eine effiziente Bereitstellung von Leistung zur Übertragung des Übertragungssignals (78) zu bewirken.

14. Verfahren entsprechend Anspruch 13, **dadurch gekennzeichnet, dass** Schritt (e) umfasst:
- Addieren der veränderten Version des Stromversorgungspegeleinstellungssignals (52') zum Verstärkungsregelungssignal (44), um das erste Leistungsregelungssignal (90') bereitzustellen, wobei die veränderte Version des Stromversorgungspegeleinstellungssignals (52') basierend auf der Ableitung des Verstärkungsregelungssignals (44') generiert wird.

15. Verfahren entsprechend Anspruch 14, **dadurch gekennzeichnet, dass** Schritt (e) das Generieren einer veränderten Version des Verstärkungsregelungssignals (44') und das Bereitstellen eines Begrenzereinstellungssignals (118) umfasst, um die beim Begrenzen verwendeten positiven und negativen Sättigungswerte und die Steilheit einzustellen, wobei das Begrenzereinstellungssignal (118) als Antwort auf eine Kombination aus dem mindestens einen Umgebungsinformationssignal (96, 100, 104) und der veränderten Version des Verstärkungsregelungssignals (44') generiert wird.

16. Verfahren entsprechend jedem der Ansprüche 13 bis 15, **dadurch gekennzeichnet, dass** Schritt (c) mindestens einen der folgenden Schritte umfasst:
Generieren eines Temperaturinformationssignals (96), das im Zusammenhang mit der Temperatur der Hardware des Funkübertragungsgeräts (10) steht, und Bereitstellen des Temperaturinformationssignals (96) als Bestandteil des mindestens einen Umgebungsinformationssignals (96, 100, 104);
Generieren eines Batteriezustandsinformationssignals (100), das im Zusammenhang mit einer Batterie steht, die zur Stromversorgung des Funkübertragungsgeräts (10) verwendet wird, und Bereitstellen des Batteriezustandsinformationssignals (100) als Bestandteil des mindestens einen Umgebungsinformationssignals (96, 100, 104); und
Generieren eines Frequenzinformationssignals (104), das im Zusammenhang mit der Frequenz steht, mit der der Ausgangsdatenstrom übertragen wird, und Bereitstellen des Frequenzinformationssignals (104) als Bestandteil des mindestens einen Umgebungsinformationssignals (96, 100, 104).

17. Verfahren entsprechend jedem der Ansprüche 13 bis 16, **dadurch gekennzeichnet, dass** das Verfahren des Weiteren das Halten des variablen Stromversorgungssignals (54) über einem minimalen Spannungspegel umfasst.

18. Funkübertragungsgerät (10), das das Leistungsverwaltungssystem (18') entsprechend jedem der Ansprüche 1 bis 12 umfasst.

19. Computerlesbares Medium mit Codemitteln, die von einem Prozessor des Geräts (10) entsprechend Anspruch 18 ausgeführt werden können, um das Verfahren entsprechend jedem der Ansprüche 13 bis 17 zu implementieren

## Revendications

1. Système régulateur de puissance (18") destiné à fournir un signal d'alimentation variable (54) à un bloc amplificateur de puissance de sortie (24) dans un dispositif de communication sans fil (10), le système régulateur de puissance (18") comprenant :
un bloc régulateur de gain et de puissance moyenne (36) devant fournir un signal régulateur de gain (44) en réponse à au moins un signal de commande de régulation de puissance (48) et un signal indicateur d'intensité du signal reçu (50) et fournir le signal régulateur de gain (44) au bloc amplificateur de puissance de sortie (24) ;
un capteur du milieu environnant (93) destiné à fournir au moins un signal d'information environnementale (96, 100, 104) ;
un générateur ajusteur du niveau d'alimentation (38') raccordé au capteur du milieu environnant (93) afin de fournir une version modifiée d'un signal régleur du niveau d'alimentation (52') en réaction à un indice de paramètre de données provenant d'un train de données de sortie d'une bande de base (76) qui doit être transmis par le dispositif de communication sans fil (10) et au moins un signal d'information environnementale (96, 100, 104) ; et,
un moyen d'alimentation en puissance (42) raccordé au bloc régulateur de gain et de puissance moyenne (36) et au générateur ajusteur du niveau d'alimentation. (38'), le moyen d'alimentation en puissance (42) fournit le signal d'alimentation variable (54) au bloc amplificateur de puissance de sortie (24) en transmettant un premier signal régulateur de puissance (90') basé sur le signal régulateur de gain (44') et la version modifiée du signal régleur du niveau d'alimentation (52'), en écrêtant le premier signal régulateur de puissance (90') pour fournir un second signal régulateur de puissance (90") et en générant le signal d'alimentation variable (54) en fonction du second signal régulateur de puissance (90"),
où le signal régulateur de gain (44) est adapté pour appliquer un gain suffisant à une version de signal de transmission (78) du train de données de sortie de la bande de base (76) et la version modifiée du signal régleur du niveau d'alimentation (52') est adaptée pour fournir une petite marge suffisante pour assurer la fourniture efficace d'une puissance destinée à transmettre le signal de transmission (78).

2. Le système régulateur de puissance (18") selon la revendication 1, où des valeurs de saturation positive et négative et une pente servant à l'écrêtage sont ajustées en fonction au moins du signal environnemental (96, 100, 104) et de la version modifiée du signal régulateur de gain.

3. Le système régulateur de puissance (18") selon l'une quelconque des revendications 1 à 2, où le bloc régulateur de gain et de puissance moyenne (36) fournit une version modifiée du signal régulateur de gain (44') et le moyen d'alimentation en puissance (42) comprend :
un dispositif sommateur (110) raccordé au bloc régulateur de gain et de puissance moyenne (36) et au générateur ajusteur du niveau d'alimentation (38') dans le but d'additionner le signal régulateur de gain (44) et la version modifiée du signal régleur du niveau d'alimentation (52') afin de générer le premier signal régulateur de puissance (90') ;
un dispositif d'écrêtage (114) raccordé au dispositif sommateur (110) afin de recevoir le premier signal régulateur de puissance (90') et de générer le second signal régulateur de puissance (90") ;
un convertisseur de commutation (72) raccordé au dispositif d'écrêtage (114) afin de recevoir le second signal régulateur de puissance (90") et de générer le signal d'alimentation variable (54) ; et,
un dispositif de topographie inversée (112) raccordé au générateur ajusteur du niveau d'alimentation (38') et au bloc régulateur de gain et de puissance moyenne (36) pour recevoir respectivement un signal environnemental (116) et la version modifiée du signal régulateur de gain (44') et pour générer un signal ajusteur de l'écrêtage (118), le dispositif de topographie inversée (112) étant également raccordé au dispositif d'écrêtage (114) afin de pouvoir fournir le signal ajusteur de l'écrêtage (118) au dispositif d'écrêtage (114) dans le but de régler les valeurs de saturation positive et négative et la pente du dispositif d'écrêtage (114).

4. Le système régulateur de puissance (18") selon l'une quelconque des revendications 1 à 3, où le capteur du milieu environnant (93) comprend un quelconque ou une combinaison des dispositifs suivants :
un capteur de température (94) devant fournir un signal d'information sur la température (96) faisant partie intégrante au moins d'un des signaux unique d'information environnementale (96, 100, 104), le signal d'information sur la température (96) étant fonction de la température de l'équipement du dispositif de communication sans fil (10) ; et,
un capteur d'état de la batterie (98) devant fournir un signal d'information sur l'état de la batterie (100) faisant partie intégrante d'au moins un des signaux unique d'information environnementale (96, 100, 104), le signal d'information sur l'état de la batterie (100) étant fonction de l'usage d'une batterie destinée à alimenter le dispositif de communication sans fil (10).

5. Le système régulateur de puissance (18") selon l'une quelconque des revendications 1 à 4, où au moins le signal unique d'information environnementale (96, 100, 104) comprend un signal d'information sur la fréquence (104) qui est fonction de la fréquence de transmission du train de données de sortie de la bande de base (76).

6. Le système régulateur de puissance (18") selon l'une quelconque des revendications 1 à 5, où le moyen d'alimentation en puissance (42) est configuré de sorte à maintenir le signal d'alimentation variable (54) au-dessus d'un niveau de tension minimum.

7. Le système régulateur de puissance (18") selon l'une quelconque des revendications 1 à 6, où le générateur ajusteur du niveau d'alimentation (38') est appliqué par une multitude de tables de consultation, où une table de consultation est fournie pour chaque signal d'information environnementale (96, 100, 104) et pour indiquer les paramètres des données, les sorties de chaque table de consultation étant combinées pour générer la version modifiée du signal régleur du niveau d'alimentation (52').

8. Le système régulateur de puissance (18") selon la revendication 7, où au moins une des tables de consultation est appliquée selon une formule correspondante.

9. Le système régulateur de puissance (18") selon l'une quelconque des revendications 1 à 8, où le système (18") comprend en outre un détecteur de paramètres de données (40) raccordé sur le générateur ajusteur du niveau d'alimentation (38') et un dispositif émetteur de bande de base (20) du dispositif de communication sans fil (10), le détecteur de paramètres de données (40) indiquant les paramètres de données.

10. Le système régulateur de puissance (18") selon la revendication 1, où le bloc d'alimentation en puissance (42) est étalonné par :
i) transmission des signaux radio du dispositif sans fil (62) à un niveau de puissance constante à partir du dispositif de communication sans fil (10) tout en contrôlant le rapport de puissance du canal adjacent (ACPR) ;
ii) réduction de l'amplitude du signal d'alimentation variable (54) tout en maintenant une puissance de sortie constante pour les signaux radio du dispositif sans fil (62) ;
iii) enregistrement de l'amplitude du signal d'alimentation variable (54) lorsque le rapport ACPR a atteint une valeur cible prédéterminée ;
iv) augmentation de la puissance de sortie des signaux radio du dispositif sans fil (62) et répétition des étapes (i) à (iii) pour différents niveaux de puissance de sortie ; et,
v) calcul d'une transmittance idéale afin d'en dériver le signal régulateur de puissance (90) destiné à réguler le convertisseur de commutation.

11. Le système régulateur de puissance (18") selon la revendication 10, où le bloc d'alimentation en puissance (42) est étalonné en outre par :
la répétition des étapes (i) à (v) pour plusieurs dispositifs différents de communication sans fil (10) afin d'obtenir une transmittance moyenne ; et,
élaboration d'une courbe de performance correspondant à la transmittance moyenne.

12. Le système régulateur de puissance (18") selon la revendication 10, où le générateur ajusteur du niveau d'alimentation (38') est étalonné par :
viii) chargement sur le générateur ajusteur du niveau d'alimentation (38') d'une valeur provoquant le fonctionnement du bloc amplificateur de puissance de sortie (24) à la valeur de puissance de transmission la plus faible ;
ix) étalonnage de la puissance de transmission jusqu'à ce que la puissance de sortie du bloc amplificateur de puissance de sortie (24) dépasse légèrement une puissance cible déterminée pour un certain niveau donné de tension d'alimentation;
x) interpolation de la valeur de sortie du bloc de puissance moyenne puis, après son réglage par topographie inversée, chargement de cette valeur de sortie interpolée sur le générateur ajusteur du niveau d'alimentation (38) ;
xi) réglage du niveau de puissance de transmission sur une valeur légèrement inférieure à la puissance ciblée ; et,
xii) augmentation de la valeur du niveau de puissance de transmission et répétition des étapes (viii) à (xi) jusqu'à l'obtention d'une valeur de puissance de transmission maximale déterminée.

13. Procédé de fourniture d'un signal d'alimentation variable (54) vers un bloc amplificateur de puissance de sortie (24) dans un dispositif de communication sans fil (10) qui reçoit un train de données d'entrée (64) provenant d'un signal radio d'une station de base (60) et émet un train de données de sortie (76) sur un signal radio d'un dispositif sans fil (62), le procédé comprenant :
a) la détection d'au moins un niveau d'intensité du signal radio de la station de base (60) afin de produire un signal indicateur de l'intensité du signal reçu (48) et un signal de commande de régulation de la puissance (50) dans le signal radio de la station de base (60) ;
b) la génération en sortie d'un signal régulateur de gain (44) en réaction à au moins un des signaux indicateurs de l'intensité du signal reçu (48) et du signal de commande de régulation de la puissance (50) ;
c) la génération d'au moins un signal d'information environnementale (96, 100, 104) afin d'obtenir une information concernant le milieu environnant le dispositif de communication sans fil (10) ;
d) la génération d'une version modifiée d'un signal régleur du niveau d'alimentation (52') en fonction d'une indication de paramètre de données provenant d'un train de données de sortie d'une bande de base (76) et au moins d'un des signaux unique d'information environnementale (96, 100, 104) ;
e) la fourniture d'un premier signal régulateur de puissance (90') en fonction du signal régulateur de gain (44) et de la version modifiée du signal régleur du niveau d'alimentation (52'), l'écrêtage du premier signal régulateur de puissance (90') pour fournir un second signal régulateur de puissance (90"), et la génération du signal d'alimentation variable (54) en fonction du second signal régulateur de puissance (90") ; et,
f) la fourniture du signal d'alimentation variable (54) et du signal régulateur de gain (44) au bloc amplificateur de puissance de sortie (24),
où le signal régulateur de gain (44) est adapté pour qu'un gain suffisant soit appliqué à une version du signal de transmission (78) du train de données de sortie de la bande de base (76) et la version modifiée du signal régleur du niveau d'alimentation (52') est adaptée pour fournir une petite marge suffisant à assurer une alimentation efficace pour émettre le signal de transmission (78).

14. Le procédé selon la revendication 13, où (e) comprend
L'addition de la version modifiée du signal régleur du niveau d'alimentation (52') et du signal régulateur de gain (44) afin de fournir le premier signal régulateur de puissance (90'), la version modifiée du signal régleur du niveau d'alimentation (52') étant générée en fonction de la dérivation du signal régulateur de gain (44').

15. Le procédé selon la revendication 14, où (e) comprend la génération d'une version modifiée du signal régulateur de gain (44') et la fourniture d'un signal ajusteur de l'écrêtage (118) afin de régler des valeurs de saturation positive et négative et la pente utilisée pour l'écrêtage, le signal ajusteur de l'écrêtage (118) étant généré en réaction à une combinaison d'au moins un des signaux d'information environnementale (96, 100, 104) et à la version modifiée du signal régulateur de gain (44').

16. Le procédé selon l'une quelconque des revendications 13 à 15, où (c) comprend au moins une des étapes suivantes :
génération d'un signal d'information sur la température (96) en fonction de la température de l'équipement du dispositif de communication sans fil (10) et fourniture de ce signal d'information sur la température (96) faisant partie d'au moins un des signaux d'information environnementale (96, 100, 104) ;
génération d'un signal d'information sur l'état de la batterie (100) en fonction d'une batterie utilisée pour alimenter le dispositif de communication sans fil (10) et fourniture de ce signal d'information sur l'état de la batterie (100) faisant partie d'au moins un des signaux d'information environnementale (96, 100, 104) ;
génération d'un signal d'information sur la fréquence (104) en fonction de la fréquence de transmission du train de données de sortie et fourniture de ce signal d'information sur la fréquence (104) faisant partie d'au moins un des signaux d'information environnementale (96, 100, 104).

17. Le procédé selon l'une quelconque des revendications 13 à 16, où le procédé comprend en outre le maintien du signal d'alimentation variable (54) au-dessus d'un niveau de tension minimum.

18. Un dispositif de communication sans fil (10) comprenant le système régulateur de puissance (18') selon l'une quelconque des revendications 1 à 12.

19. Un moyen lisible par ordinateur comprenant un moyen de codage pouvant être exécuté par un processeur du dispositif (10) selon la revendication 18 afin d'appliquer le procédé selon l'une quelconque des revendications 13 à 17.
